# EUROPEAN PATENT APPLICATION

(11) **EP 4 783 757 A1**
(43) Date of publication of application: **29.07.2026**
(21) Application number: 25154132.2
(22) Date of filing: 27.01.2025
(51) Int. Cl.: H05K 7/14

(54) **CONVERTER ASSEMBLY**

(71) Applicant: ABB Schweiz AG, 5400 Baden (CH)
(72) Inventor: Savolainen, Jari Tapio, 00380 Helsinki (FI); Palojoki, Vesa, 00380 Helsinki (FI); Mielonen, Matti, 00380 Helsinki (FI); Kauranen, Matti, 00980 Helsinki (FI)
(74) Representative: Kolster Oy Ab

(57) **Abstract**

A converter assembly comprising: a frame (2); a plurality of electrical components mounted on the frame (2), wherein the plurality of electrical components includes an electrical converter; a converter connector system mounted on the frame (2), wherein the converter connector system includes at least one input connector (61) and at least one output connector (62); and a cabling wall (8) comprising a plurality of cabling apertures (85). Each of the cabling apertures (85) extends through the cabling wall (8) in a longitudinal direction and is adapted for receiving a cable (10). The converter assembly comprises a cabling module (12) adapted to be removably fastened to the frame (2) into an operational position, wherein the cabling module (12) comprises the cabling wall (8).

## Description

### FIELD OF THE INVENTION

The present invention relates to a converter assembly.

### BACKGROUND OF THE INVENTION

A known converter assembly comprises a frame, a plurality of electrical components mounted on the frame, and a cabling wall having a plurality of cabling apertures. The plurality of electrical components includes an electrical converter, and the cabling apertures are adapted to receive a plurality of cables for electrically connecting the electrical converter to a power supply and to a load.

One of the problems associated with the known converter assembly is that maintenance or replacement of some of the plurality of electrical components is laborious since the cables block access to the electrical components, and the cabling wall prevents bending the cables sufficiently to provide the access to the electrical components without damaging the cables.

### BRIEF DESCRIPTION OF THE INVENTION

An object of the present invention is to provide a converter assembly so as to solve the above problem. The objects of the invention are achieved by a converter assembly characterized by what is stated in the independent claim. The preferred embodiments of the invention are disclosed in the dependent claims.

The invention is based on the idea of providing a converter assembly with a cabling module adapted to be removably fastened to a frame of the converter assembly. The removable cabling module comprises a cabling wall having a plurality of cabling apertures through which cables connected to a converter connector system extend in an operational state of the converter assembly.

An advantage of the converter assembly of the invention is that the removable cabling module facilitates maintenance of the converter assembly by enabling moving the cabling wall relative to the frame of the converter assembly. The removable cabling module enables moving cables further from electrical components requiring maintenance while maintaining bending radii of the cables within an allowable range. Consequently, cables blocking access to electrical components requiring maintenance can be moved out of the way without a need to withdraw the cables from the cabling apertures or to bend the cables excessively. Further, the removable cabling module enables replacing the frame of the converter assembly, together with electrical components mounted on the frame, without a need to withdraw cables from the plurality of cabling apertures or to bend the cables excessively.

### BRIEF DESCRIPTION OF THE DRAWINGS

In the following the invention will be described in greater detail by means of preferred embodiments with reference to the attached drawings, in which
Figure 1 shows a converter assembly according to an embodiment of the invention;
Figure 2 shows the converter assembly of Figure 1 without a front cover and side covers;
Figure 3 is a side view of the converter assembly shown in Figure 2;
Figure 4 shows the converter assembly of Figure 2 in a situation in which a cabling module has been unfastened from a frame of the converter assembly; and
Figure 5 is a side view of the converter assembly shown in Figure 4.

### DETAILED DESCRIPTION OF THE INVENTION

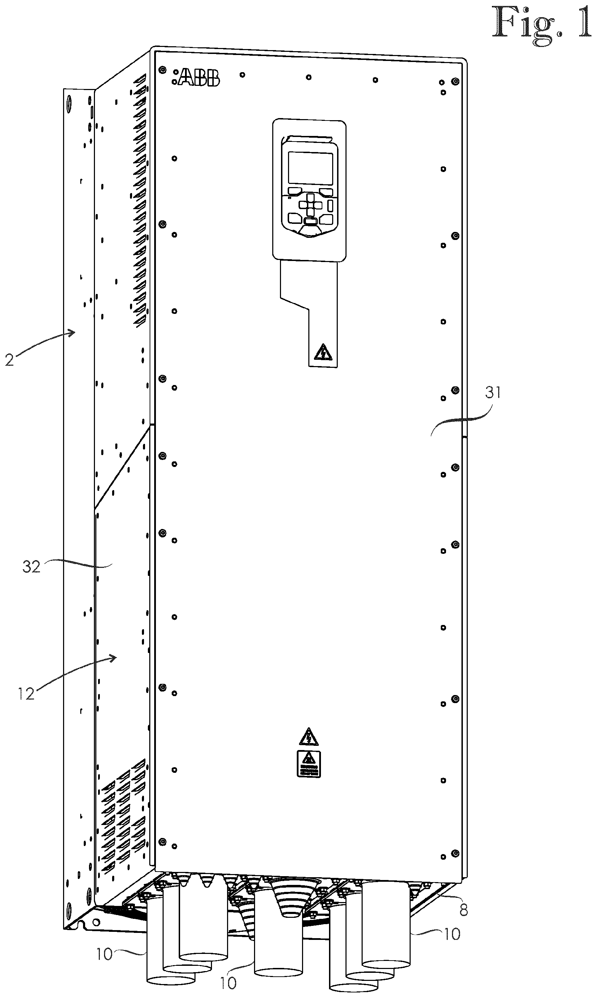

Figure 1 shows a converter assembly comprising a frame 2, a front cover 31, side covers 32, a plurality of electrical components mounted on the frame 2, a cabling module 12, a converter connector system, a cabling module connector system and seven cables 10 electrically connected to the plurality of electrical components.

The cabling module 12 is removably fastened to the frame 2 by means of a plurality of bolt joints. In an alternative embodiment, the cabling module is adapted to be removably fastened to the frame by means of at least one bolt joint.

In Figure 1, the cabling module 12 is in an operational position relative to the frame 2.

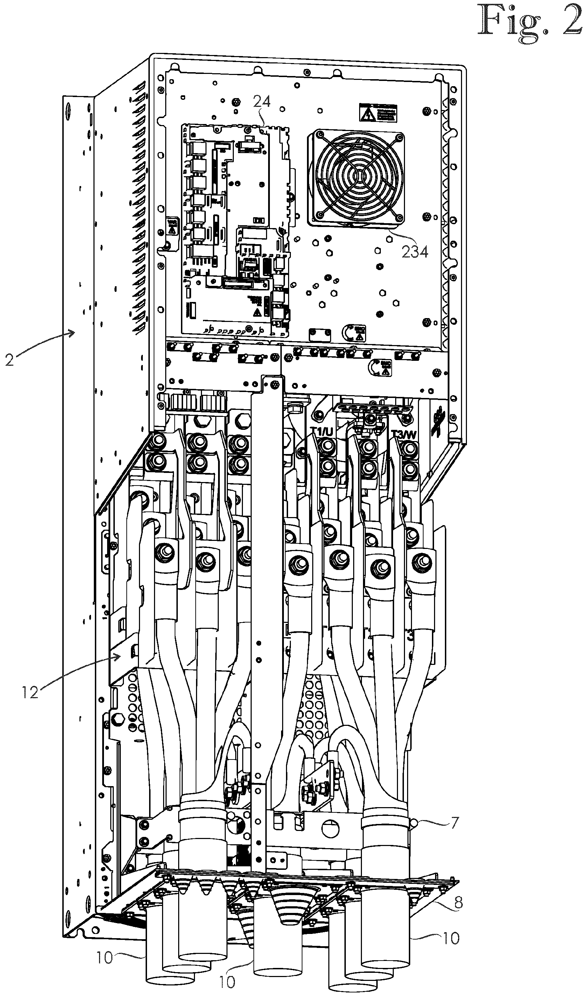

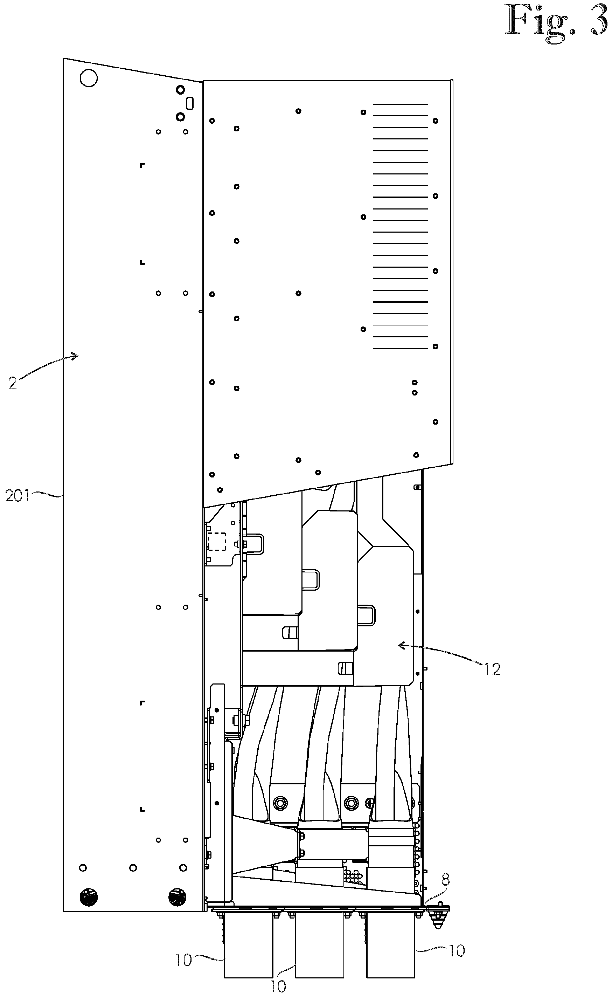

Figure 2 shows the converter assembly of Figure 1 without the front cover 31 and side covers 32. Figure 3 is a side view of the converter assembly shown in Figure 2.

The frame 2 has a back wall 201 defining a back wall plane. The back wall plane is parallel to a plane defined by a longitudinal direction and a width direction perpendicular to the longitudinal direction. In Figure 3, the longitudinal direction is the vertical direction, and the width direction is perpendicular to the image plane.

The converter assembly is adapted to be mounted on a wall of an assembly space such that the back wall 201 is adjacent to the wall of the assembly space, and the back wall plane is parallel to a plane defined by the wall of the assembly space. In an embodiment, the assembly space is a room of a building. In another embodiment, the assembly space is an engine room of a ship. In yet another embodiment, the assembly space is an electrical cabinet.

The frame 2 is provided with at least one support member for supporting the frame 2 to an assembly space. In an embodiment, the at least one support member comprises at least one leg by means of which the frame is adapted to stand on a floor. In another embodiment, the at least one support member comprises at least one bolt hole each one of which is adapted to receive a bolt for connecting the frame to a wall or a floor.

A width of the cabling module 12 is substantially equal to a width of the frame 2. In the longitudinal direction and in a depth direction perpendicular to both the longitudinal direction and the width direction, a dimension of the cabling module 12 is roughly half the dimension of the frame 2. In an alternative embodiment, a ratio between dimensions of the cabling module and the frame in the width direction is in a range of 50-105%, a ratio between dimensions of the cabling module and the frame in the longitudinal direction in a range of 20-105%, and a ratio between dimensions of the cabling module and the frame in the depth direction in a range of 10-90%.

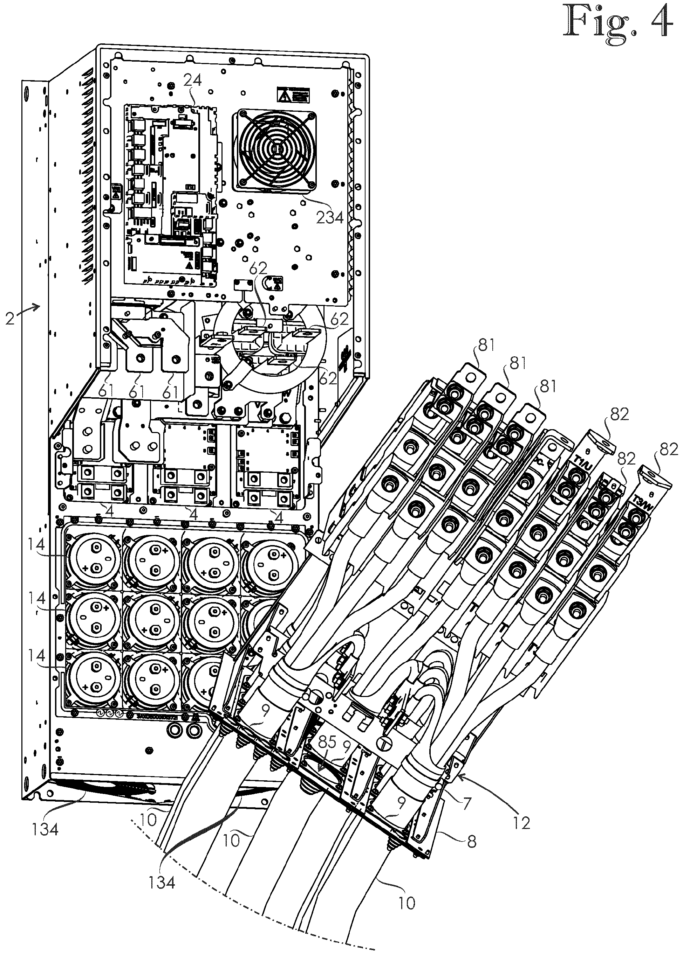

Figure 4 shows the converter assembly of Figure 2 in a situation in which the cabling module 12 has been unfastened from the frame 2 of the converter assembly and moved further from the frame 2.

The plurality of electrical components mounted on the frame 2 includes an electrical converter, twelve capacitors 14, a control unit 24, two main fans 134 and an auxiliary fan 234. The electrical converter has three semiconductor switch units 4. The control unit 24 is adapted to control the semiconductor switch units 4. The two main fans 134 are adapted for cooling the electrical converter and the capacitors 14. The auxiliary fan 234 is adapted for cooling the control unit 24. In an alternative embodiment, the converter assembly comprises at least one main fan adapted for cooling the electrical converter.

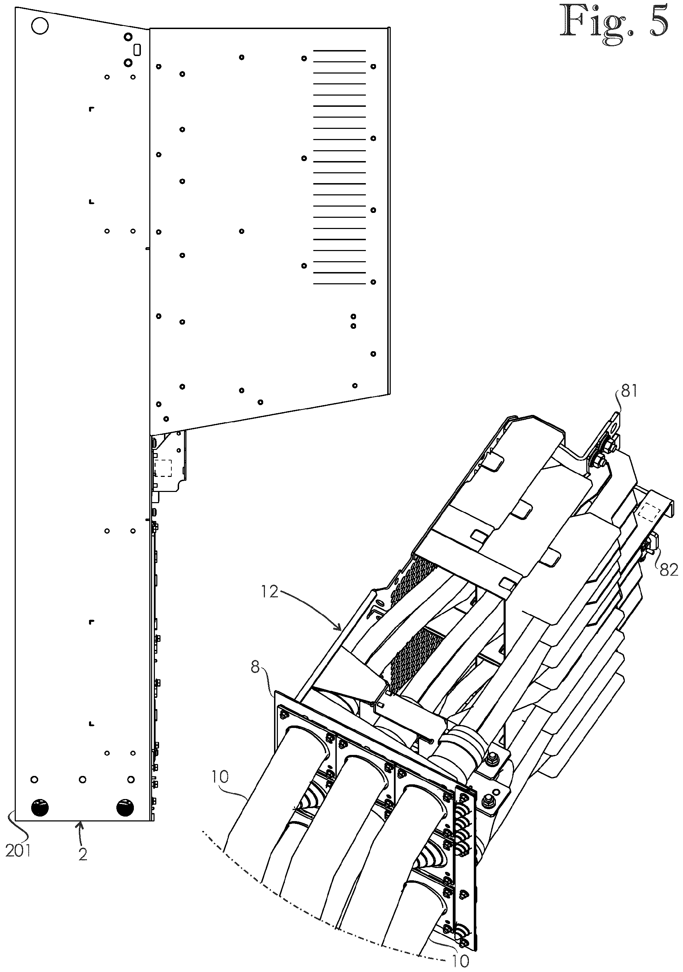

In the embodiment shown in Figures 1 to 5, the electrical converter is a frequency converter. Input and output power of the frequency converter is adapted to pass through the semiconductor switch units 4. The capacitors 14 are electrically connected to a DC intermediate circuit of the frequency converter.

In an alternative embodiment, the electrical converter is another type of converter adapted to convert electric energy from one form to another. Examples of electrical converter comprise an inverter, a rectifier and a DC-to-DC converter.

In an embodiment, the nominal input voltage of the electrical converter is greater than or equal to 100V, and the nominal power of the electrical converter is greater than or equal to 20kVA.

The converter connector system is mounted on the frame 2. The converter connector system includes three input connectors 61 and three output connectors 62.

Each input connector 61 is electrically connected to an input of the electrical converter and is adapted to be electrically connected to a power supply. Each input connector 61 comprises an internal thread for connecting the input connector 61 to a counterpart connector by means of a bolt joint.

Each output connector 62 is electrically connected to an output of the electrical converter and is adapted to be electrically connected to a load. Each output connector 62 comprises a bolt hole for connecting the output connector 62 to a counterpart connector by means of a bolt joint.

The cabling module 12 has a cabling wall 8 comprising nine cabling apertures 85. The cabling apertures 85 are circular apertures. In an embodiment, a surface area of each of the cabling apertures is greater than or equal to 100mm². In an alternative embodiment, a surface area of each of the cabling apertures is greater than or equal to 200mm².

In the operational position of the cabling module 12, each of the cabling apertures 85 extends through the cabling wall 8 in the longitudinal direction and is adapted for receiving a cable. In Figure 1, seven of the cabling apertures 85 accommodates a cable 10 each while two of the cabling apertures are vacant.

The cabling wall 8 defines a cabling wall plane. In the operational position of the cabling module 12, a normal of the cabling wall plane is parallel to the longitudinal direction. In an alternative embodiment, in the operational position of the cabling module, an angle between a normal of the cabling wall plane and the longitudinal direction is less than or equal to 20°.

There is a lead-through seal 9 between each of the plurality of cables 10 and an edge of a corresponding cabling aperture 85. Further, the vacant cabling apertures are blocked by seals. Each of the cables 10 is fastened to the cabling module 12 with a corresponding cable clamp 7.

Each of the cables 10 has three conductors such that a total cross-sectional area of the conductors is 75mm². In an alternative embodiment, each of the cables has at least one conductor such that a total cross-sectional area of the at least one conductor is greater than or equal to 25mm².

In an embodiment, the distance in the longitudinal direction between the converter connector system and the cabling wall is greater than or equal to 150mm. Herein, the distance between the converter connector system and the cabling wall is the shortest distance in the longitudinal direction between the cabling wall and any one of the input connectors and output connectors. Typically, a minimum distance between the converter connector system and the cabling wall is determined by bending space requirements or bending radius requirements given in relevant standards.

The plurality of electrical components mounted on the frame 2 includes a first set of components such that on the back wall plane, a projection of the first set of components at least partially overlaps with a projection of the cabling module 12, and the first set of components is located between the back wall 201 and the cabling module 12 in the depth direction perpendicular to the back wall plane. In other words, in the operational position of the cabling module 12, components of the first set of components are at least partially located behind the cabling module 12. Further, in the operational state of the converter assembly, components of the first set of components are at least partially located behind the cables 10.

The first set of components comprises the semiconductor switch units 4 and the capacitors 14. In an alternative embodiment, the first set of components comprises at least one choke coil electrically connected to output connectors of the frequency converter.

The cabling module connector system is mounted on the cabling module 12 and is stationary relative to the the cabling wall 8. The cabling module connector system is adapted to be electrically conductively connected to the converter connector system by means of a plurality of bolt joints. The cabling module connector system is adapted to be electrically conductively connected to the cables 10 extending through the plurality of cabling apertures 85.

The cabling module connector system comprises three input connectors 81 adapted to be electrically connected to the input connectors 61 of the converter connector system, and three output connectors 82 adapted to be electrically connected to the output connectors 62 of the converter connector system. In an alternative embodiment, the cabling module connector system is adapted to be electrically conductively connected to the converter connector system by means of a removable connection provided without bolts or nuts.

In the converter assembly shown in Figures 1 to 5, each of the cables 10 extending through the cabling apertures 85 of the cabling wall 8 is adapted to be electrically connected to exactly one connector of the converter connector system. In an alternative embodiment, a plurality of cables extending through the cabling apertures of the cabling wall comprises at least one set of cables having a plurality of individual cables, wherein in the operational state of the converter assembly, each cable of the at least one set of cables is electrically connected to a single electrical connector of the converter connector system.

In an embodiment, the converter connector system comprises at least one alternating current connector such that in the operational state of the converter assembly, at least one set of cables having a plurality of individual cables extending through the cabling apertures of the cabling wall is electrically connected to exactly one of the at least one alternating current connector. For example, the converter assembly shown in Figures 1 to 5 could be modified such that the cables extending through the cabling wall comprise a plurality of individual cables electrically conductively connected to a common cable connector of the cabling module connector system, wherein the common cable connector is adapted to be electrically conductively connected to a single input connector of the converter connector system.

It will be obvious to a person skilled in the art that the inventive concept can be implemented in various ways. The invention and its embodiments are not limited to the examples described above but may vary within the scope of the claims.

## Claims

1. A converter assembly comprising:
a frame (2);
a plurality of electrical components mounted on the frame (2), wherein the plurality of electrical components includes an electrical converter having at least one semiconductor switch unit (4);
a converter connector system mounted on the frame (2), wherein the converter connector system includes at least one input connector (61) and at least one output connector (62), wherein the at least one input connector (61) is electrically connected to an input of the electrical converter, and the at least one output connector (62) is electrically connected to an output of the electrical converter; and
a cabling wall (8) comprising a plurality of cabling apertures (85), wherein each of the cabling apertures (85) extends through the cabling wall (8) in a longitudinal direction, and is adapted for receiving a cable (10),
**characterized in that** the converter assembly comprises a cabling module (12) adapted to be removably fastened to the frame (2) into an operational position, wherein the cabling module (12) comprises the cabling wall (8).

2. The converter assembly according to claim 1, wherein in the operational position of the cabling module (12), a distance in the longitudinal direction between the converter connector system and the cabling wall (8) is greater than or equal to 150mm.

3. The converter assembly according to claim 1 or 2, wherein the nominal input voltage of the electrical converter is greater than or equal to 100V, and the nominal power of the electrical converter is greater than or equal to 20kVA.

4. The converter assembly according to any one of the preceding claims, wherein the frame (2) has a back wall (201) defining a back wall plane, wherein the back wall plane is parallel to a plane defined by the longitudinal direction and a width direction perpendicular to the longitudinal direction.

5. The converter assembly according to claim 4, wherein the converter assembly is adapted to be mounted on a wall of an assembly space such that the back wall (201) is adjacent to the wall of the assembly space, and the back wall plane is parallel to a plane defined by the wall of the assembly space.

6. The converter assembly according to claim 4 or 5, wherein the plurality of electrical components includes a first set of components such that on the back wall plane, a projection of the first set of components at least partially overlaps with a projection of the cabling module (12), and the first set of components is located between the back wall and the cabling module (12) in a depth direction perpendicular to the back wall plane.

7. The converter assembly according to any one of the preceding claims, wherein the converter assembly comprises a cabling module connector system mounted on the cabling module (12), wherein the cabling module connector system is adapted to be electrically conductively connected to the converter connector system by means of a removable connection, and the cabling module connector system is adapted to be electrically conductively connected to a plurality of cables (10) extending through the plurality of cabling apertures (85).

8. The converter assembly according to any one of the preceding claims, wherein the cabling module (12) is adapted to be removably fastened to the frame (2) by means of at least one bolt joint.

9. The converter assembly according to any one of the preceding claims, wherein each of the at least one input connector (61) comprises an internal thread for connecting the input connector (61) to a counterpart connector, and/or each of the at least one output connector (62) comprises an internal thread for connecting the output connector (62) to a counterpart connector.

10. The converter assembly according to any one of the preceding claims, wherein the converter assembly comprises a plurality of cables (10) extending through the plurality of cabling apertures (85), wherein each of the plurality of cables (10) has at least one conductor such that a total cross-sectional area of the at least one conductor is greater than or equal to 25mm².

11. The converter assembly according to claim 10, wherein the plurality of cables (10) comprises at least one set of cables having a plurality of individual cables (10), wherein in the operational position of the cabling module (12), each cable (10) of the at least one set of cables is electrically connected to a single electrical connector of the converter connector system.

12. The converter assembly according to claim 11, wherein the converter connector system comprises at least one alternating current connector, and the at least one set of cables is electrically connected to a single phase, wherein in the operational position of the cabling module (12), each cable (10) of the at least one set of cables is electrically connected to a single alternating current connector of the converter connector system.

13. The converter assembly according to claim 11 or 12, wherein each cable (10) of the at least one set of cables is electrically conductively connected to a single cable connector adapted to be electrically conductively connected to the single electrical connector of the converter connector system.

14. The converter assembly according to any one of claims 10 to 13, wherein there is a lead-through seal (9) between each of the plurality of cables (10) and an edge of a corresponding cabling aperture (85).

15. The converter assembly according to any one of claims 10 to 14, wherein each of the plurality of cables (10) is fastened to the cabling module (12) with a corresponding cable clamp (7).
